# NEUE EUROPÄISCHE PATENTSCHRIFT

(11) **EP 2 659 529 B2**
(45) Veröffentlichungstag und Bekanntmachung des Hinweises auf die Entscheidung über den Einspruch: **28.03.2018**
(45) Hinweis auf die Patenterteilung: 19.08.2015
(21) Anmeldenummer: 11805513.6
(22) Anmeldetag: 22.12.2011
(51) Int. Cl.: H01L 51/50, H01L 51/54, H01L 51/42, H01L 51/46, C09B 57/10

(54) **OPTOELEKTRONISCHES BAUELEMENT MIT DOTIERTEN SCHICHTEN**
OPTOELECTRONIC COMPONENT HAVING DOPED LAYERS
COMPOSANT OPTOÉLECTRONIQUE À COUCHES DOPÉES

(30) Priorität: 27.12.2010 DE 102010056519
(43) Veröffentlichungstag der Anmeldung: 06.11.2013
(73) Patentinhaber: Heliatek GmbH, 01139 Dresden (DE)
(72) Erfinder: WEISS, Andre, 89081 Ulm (DE); MÄNNIG, Bert, 01127 Dresden (DE); MATTERSTEIG, Gunter, 89075 Ulm (DE)
(86) Internationale Anmeldenummer: PCT/EP2011/073852
(87) Internationale Veröffentlichungsnummer: WO 2012/089624

(56) Entgegenhaltungen:
- WO-A1-2008//154914
- US-A1- 2005 156 197
- US-A1- 2009 211 640
- LUTZ&EMSP14;O. MÜLLER ET AL: "Ein leichter Zugang zur nicht-oxidierenden Lewis-Supersäure PhF->Al(OR F ) 3 (R F =C(CF 3 ) 3 )", ANGEWANDTE CHEMIE (INTERNATIONAL ED. IN ENGLISH), Bd. 120, Nr. 40, 22. September 2008 (2008-09-22), Seiten 7772-7776, XP55021137, ISSN: 0044-8249, DOI: 10.1002/ange.200800783
- KROSSING I. ET AL: 'Relative stabilities of weakly coordinating anions: A computational study' JOURNAL CHEM. EUR. Bd. 10, 2004, Seiten 5017 - 5030
- CHRISTE K.O. ET AL: 'On aquantitative scale for Lewis acidity and recent progress in polynitrogen chemistry' JOURNAL OF FLUORINE CHEMISTRY Bd. 101, 2000, Seiten 151 - 153
- RAAB V. ET AL: '1,8-Bis(tetramethylguanidino)naphthalene (TMGN): A new, superbasic and kinetically active "Proton Sponge"' JOURNAL CHEM. EUR. Bd. 8, Nr. 7, 2002, Seiten 1682 - 1693
- SCHWESINGER R. ET AL: 'Extremely strong, uncharged auxiliary bases; Monomeric and Polymer-supported polyaminophosphazenes (P2-P5)' LIEBIGS ANN. 1996, Seiten 1055 - 1081

## Beschreibung

Die Erfindung betrifft neue Dotanden für organische Systeme und Schichtsysteme, die Verwendung dieser zur Dotierung eines organischen halbleitenden Matrixmaterials, als Ladungsinjektionsschicht, als Löcherblockerschicht, als Elektrodenmaterial, als Transportmaterial selbst, als Speichermaterial in elektronischen oder optoelektronischen Bauelementen und die Verwendung von mit diesen dotierten Matrixmaterialien in organischen elektronischen oder optoelektronischen Bauelementen, sowie organische optoelektronische Bauelemente mit diesen Dotanden.

Es ist bekannt, dass organische Halbleiter durch Dotierung hinsichtlich ihrer elektrischen Eigenschaften, insbesondere ihrer elektrischen Leitfähigkeit verändert werden können, wie dies auch bei anorganischen Halbleitern wie Siliziumhalbleitern der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungsträgertransportschichten, wodurch ohmsche Verluste verringert werden, und zu einem verbesserten Übergang der Ladungsträger zwischen Kontakten und organischer Schicht. Anorganische Dotanden wie Alkalimetalle (z. B. Cäsium) oder Lewis-Säuren (z. B. FeCl3; SbCl5) sind bei organischen Matrixmaterialien aufgrund ihrer hohen Diffusionskoeffizienten meist nachteilig, da die Funktion und Stabilität der elektronischen Bauelemente beeinträchtigt wird (siehe D. Oeter, Ch. Ziegler, W. Göpel Synthetic Metals (1993) 61 147; Y. Yamamoto et al. (1965) 2015, J. Kido et al. Jpn J. Appl. Phys. 41 (2002) L358). Überdies weisen letztere Dotanden einen so hohen Dampfdruck auf, dass ein technischer Einsatz sehr fraglich ist. Außerdem sind die Reduktionspotentiale dieser Verbindungen oft zu niedrig, um technisch wirklich interessante Lochleitermaterialien zu dotieren. Zusätzlich erschwert das äußerst aggressive Reaktionsverhalten dieser Dotanden eine technische Anwendung.

Die Verwendung von dotierten organischen Schichten bzw. Schichtsystemen in organischen Bauelementen, speziell organischen Solarzellen und organischen Leuchtdioden ist bekannt (z.B. WO2004083958). Dabei wurden verschiedene Materialien bzw. Materialklassen als Dotanden vorgeschlagen wie in DE102007018456, WO2005086251, WO2006081780, WO2007115540, WO2008058525, WO2009000237 und DE102008051737 beschrieben. WO2008154914A1 offenbart die Verwendung von Dirhodium-Metallkomplexe als p-Dotanden für ein organisches halbleitendendes Matrixmaterial.

Ferner ist es bekannt, Dotanden über chemische Reaktionen in dem halbleitenden Matrixmaterial freizusetzen, um Dotanden bereitzustellen. Das Reduktionspotential der derart freigesetzten Dotanden ist jedoch für verschiedene Anwendungsfälle, wie etwa für organische Leuchtdioden (OLED), oftmals nicht ausreichend. Ferner werden bei Freisetzung der Dotanden auch weitere Verbindungen und/oder Atome, beispielsweise atomarer Wasserstoff, erzeugt, wodurch die Eigenschaften der dotierten Schicht bzw. des korrespondierenden elektronischen Bauelementes beeinträchtigt werden.

Der vorliegenden Erfindung liegt die Aufgabe zugrunde, neue Dotanden für die Anwendung in elektronischen und optoelektronischen Bauelementen zur Verfügung zu stellen, die die Nachteile aus dem Stand der Technik überwinden.

Insbesondere sollen die neuen Dotanden ausreichend hohe Redoxpotentiale aufweisen, ohne störende Einflüsse auf das Matrixmaterial sein und eine wirksame Erhöhung der Ladungsträgeranzahl im Matrixmaterial bereitstellen und vergleichsweise einfach handhabbar sein.

Erfindungsgemäß wird die Aufgabe durch Verbindungen, mit mindestens 10 Atomen gelöst, die eine stärkere Lewis-Base als 1,8-bis-(dimethylamino)-napthalen und als Dotanden in organischen elektronischen und optoelektronischen Bauelementen eingesetzt werden.

Unter Dotanden sind Verbindungen gemeint, die mit höchsten 35%, bevorzugt aber höchstens 30%, Masseanteil in einer Schicht, bevorzugt einer Ladungsträgertransportschicht, des Schichtsystems eines organischen elektronischen oder optoelektronischen Bauelements vorkommt. Die erfindungsgemäßen Verbindungen können auch als meist dünne Einzelschichten eingesetzt werden, bevorzugt ist aber ihre Verwendung als Dotanden in einem Matrixmaterial.

Die erfindungsgemäßen Verbindungen können organische, organometallische oder anorganische Verbindungen sein, bevorzugt aber sind es organische oder organometallische Verbindungen.

Die erfindungsgemäßen Lewis-Basen sind stark nucleophil und werden daher als n-Dotanden in elektronischen oder optoelektronischen Bauelementen eingesetzt.

Die starken Lewis-Säuren sind in der Fachwelt auch als Supersäuren bekannt. Diese sind unter anderem in der Lage die ausgesprochen reaktionsträgen Edelgase zu protonieren. Ein Einsatz als Dotanden wurde wegen ihrer hohen Reaktivität lange ausgeschlossen, da für die technische Einsetzbarkeit entscheidend ist, dass sie nicht mit dem Matrixmaterial reagieren, sondern es p- bzw. n-dotieren.

Überraschenderweise konnte gefunden werden, dass ein Einsatz von erfindungsgemäßen Verbindungen als Dotanden in organischen elektronischen und optoelektronischen Bauelementen trotz der hohen Reaktivität möglich ist. Bevorzugt verfügen dabei die erfindungsgemäßen Lewis-Basen über verzweigte Seitenketten oder andere raumgreifende Gruppen, die das reaktive Zentrum sterisch abschirmen.

In einem erfindungsgemäßen Bauelement können sowohl die Ladungstransportschichten, als auch die aktiven Schichten dotiert werden, meist sind es aber die Ladungsträgertransportschichten. Daneben können verschiedene Einzel- oder Mischschichten vorhanden sein. Aus Gründen der Langzeitstabilität kann es vorteilhaft sein, das Transportsystem aus einem Schichtsystem mit dotieren und undotierten Schichten aufzubauen. Daneben sind als Excitonenblockerschichten dünne Schichten bekannt, für die die Verwendung der erfindungsgemäßen Verbindungen als undotierte Einzelschicht denkbar sein könnte.

Unter organischen elektronischen und optoelektronischen Bauelementen werden Bauelemente verstanden, die mindestens eine organische Schicht im Schichtsystem aufweisen. Ein organisches elektronisches und optoelektronisches Bauelement kann unter anderem eine OLED, eine organische Solarzelle, ein Feldttransistor (OFET) oder ein Fotodetektor sein, besonders bevorzugt ist die Anwendung in organischen Solarzellen.

In einer Ausführungsform enthalten die erfindungsgemäßen Verbindungen mindestens 10, bevorzugt 20, besonders bevorzugt aber mehr als 30 und maximal 100 Atome. Hierdurch sind die erfindungsgemäßen Verbindungen groß und schwer genug, damit sie nur einen geringen Diffusionskoeffizienten in der Matrix aufweisen, was für eine gute Funktion und eine hohe Stabilität und Lebensdauer der elektronischen Bauelemente wichtig ist, und klein genug um über Verdampfung technisch einsetzbar zu sein.

In einer Ausführungsform der erfindungsgemäßen Verbindungen werden Verbindungen der allgemeinen Formel III

((R₂N)₂C=N)ₙAr (III)

verwendet, wobei R unabhängig voneinander C₁-C₅-Alkyl, jeweils substituiert oder unsubstituiert ist, wobei zwei benachbarte R miteinander verbunden sein können, und Ar ein Aryl oder Heteroaryl, bevorzugt aber Phenyl, Naphtyl oder Anthryl, und n eine ganze Zahl, bevorzugt 2, 3 oder 4 ist.

In einer vorteilhaften Ausführungsform der Erfindung absorbieren die photoaktiven Schichten des Bauelementes möglichst viel Licht. Hierzu wird der Spektralbereich, in dem das Bauelement Licht absorbiert, möglichst breit gestaltet.

In einer vorteilhaften Ausgestaltung der obigen Ausführungsform der Erfindung besteht das i-Schichtsystem des photoaktiven Bauelementes aus einer Doppelschicht oder Mischschichten von 2 Materialien oder aus einer Doppelmischschicht oder einer Mischschicht mit angrenzender Einzelschicht aus mindestens 3 Materialien.

In einer weiteren Ausführungsform der Erfindung können zur Verbesserung der Ladungsträgertransporteigenschaften der Doppelmischschicht die Mischungsverhältnisse in den verschiedenen Mischschichten gleich oder auch unterschiedlich sein, wobei die Zusammensetzung gleich oder verschieden ist.

In einer weiteren Ausführungsform der Erfindung kann in den einzelnen Mischschichten ein Gradient des Mischungsverhältnisses vorhanden sein, wobei der Gradient in Richtung der Kathode oder Anode ausgebildet ist.

In einer Ausgestaltung der Erfindung ist das organische elektronische oder optoelektronische Bauelement als Tandemzellen oder Mehrfachzelle ausgeführt, etwa als Tandemsolarzelle oder Tandemmehrfachzelle.

In einer weiteren Ausführungsform der Erfindung besteht das organische elektronische oder optoelektronische Bauelement, insbesondere eine organische Solarzelle, aus einer Elektrode und einer Gegenelektrode und zwischen den Elektroden wenigstens einer photoaktiven Schicht und mindestens einer dotierten Schicht zwischen der photoaktiven Schicht und einer Elektrode, die bevorzugt als Ladungsträgertransportschicht dient.

In einer weiteren Ausführungsform der Erfindung sind eine oder mehrere der weiteren organischen Schichten dotierte wide-gap Schichten, wobei das Maximum der Absorption bei < 450nm liegt.

In einer weiteren Ausführungsform der Erfindung sind die HOMO- und LUMO-Niveaus der Hauptmaterialien so angepasst, dass das System eine maximale Leerlaufspannung, einen maximalen Kurzschlussstrom und einen maximalen Füllfaktor ermöglicht.

In einer weiteren Ausführungsform der Erfindung handelt es sich bei den verwendeten organischen Materialien für photoaktive Schichten um kleine Moleküle.

In einer weiteren Ausführungsform der Erfindung handelt es sich bei den verwendeten organischen Materialien für die photoaktiven Schichten zumindest teilweise um Polymere.

In einer weiteren Ausführungsform der Erfindung enthält die photoaktive Schicht als Akzeptor ein Material aus der Gruppe der Fullerene bzw. Fullerenderivate (C₆₀, C₇₀, etc.).

In einer weiteren Ausführungsform der Erfindung enthält mindestens eine der photoaktiven Mischschichten als Donator ein Material aus der Klasse der Phthalocyanine, Perylenderivate, TPD-Derivate, Oligothiophene oder ein Material wie es in WO2006092134 oder DE102009021881 beschrieben ist.

Die erfindungsgemäßen Bauelemente können auf verschiedene Weise hergestellt werden. Die Schichten des Schichtsystems können in flüssiger Form als Lösung oder Dispersion durch Drucken oder coaten aufgetragen werden oder durch Aufdampfen zum Beispiel mittels CVD, PVD oder OVPD aufgetragen werden.

Unter dem Begriff der Verdampfungstemperatur wird im Sinne der Erfindung diejenige Temperatur verstanden, die benötigt wird, um bei einer gegebenen Verdampfergeometrie (Referenz: Quelle mit einer kreisförmigen Öffnung (1cm Durchmesser) im Abstand von 30cm von einem senkrecht darüber angebrachten Substrat) und einem Vakuum im Bereich 10⁻⁴ bis 10⁻¹⁰ mbar eine Aufdampfrate von 0.1nm/s an der Position des Substrates zu erreichen. Hierbei ist es unerheblich, ob es sich dabei um eine Verdampfung im engeren Sinn (Übergang aus der flüssigen Phase in die Gasphase) oder eine Sublimation handelt.

Bei der Schichtbildung durch Aufdampfen entstehen daher bevorzugt solche Strukturen, bei denen die intermolekularen Wechselwirkungen innerhalb der Schicht maximiert werden, so dass die Grenzflächen, die starke Wechselwirkungen eingehen können an der Schichtoberfläche vermieden werden.

In der Literatur beschriebene organische Solarzellen aus Vakuumdeposition nicht-polymerer organischer Moleküle, sogenannte kleine Moleküle, sind bis auf wenige Ausnahmen (Drechsel, Org. Electron., 5, 175 (2004); J. Drechsel, Synthet. Metal., 127, 201-205 (2002)) so aufgebaut, dass der sogenannte Grundkontakt, auf dem die organischen Schichten abgeschieden werden, die Anode bildet (falls die Struktur eine ausschließlich löcherleitende oder p-dotierte Schicht umfasst, grenzt diese an den Grundkontakt). Bei der Anode handelt es sich in der Regel um ein transparentes leitfähiges Oxid (oft Indium-Zinn-Oxid, abgekürzt ITO; es kann sich aber auch um ZnO:Al handeln), es kann aber auch eine Metallschicht oder eine Schicht aus einem leitfähigen Polymer sein. Nach Abscheidung des organischen Schichtsystems, welcher die photoaktive Mischschicht umfasst, wird eine - meist metallische - Kathode abgeschieden.

In einer weiteren Ausführungsform der Erfindung ist das Bauelement aufgebaut als Einzelzelle mit der Struktur nip, ni, ip, pnip, pni, pip, nipn, nin, ipn, pnipn, pnin, pipn, nip, ip ni, pnip, nipn oder pnipn, wobei n eine negativ dotierte Schicht ist, i eine intrinsische Schicht ist, welche undotiert oder schwach dotiert ist und p eine positiv dotierte Schicht ist.

In einer weiteren Ausführungsform der Erfindung ist das Bauelement aufgebaut als Tandemzelle aus einer Kombination aus nip, ni, ip, pnip, pni, pip, nipn, nin, ipn, pnipn, pnin oder pipn-Strukturen.

In einer besonders bevorzugten Ausführungsform der oben beschriebenen Strukturen ist diese als eine pnipnipn-Tandemzelle ausgeführt.

In einer weiteren Ausführungsform liegt das Akzeptor-Material in der Mischschicht zumindest teilweise in kristalliner Form vor.

In einer weiteren Ausführungsform liegt das Donator-Material in der Mischschicht zumindest teilweise in kristalliner Form vor.

In einer weiteren Ausführungsform liegen sowohl das Akzeptor-Material als auch das Donator-Material in der Mischschicht zumindest teilweise in kristalliner Form vor.

In einer weiteren Ausführungsform verfügt das Akzeptor-Material über ein Absorptionsmaximum im Wellenlängenbereich > 450nm.

In einer weiteren Ausführungsform verfügt das Donator-Material über ein Absorptionsmaximum im Wellenlängenbereich > 450nm.

In einer weiteren Ausführungsform besteht das n-Materialsystem aus einer oder mehreren Schichten.

In einer weiteren Ausführungsform besteht das p-Materialsystem aus einer oder mehreren Schichten.

In einer weiteren Ausführungsform enthält das n-Materialsystem eine oder mehrere dotierte wide-gap Schichten. Der Begriff wide-gap Schichten definiert dabei Schichten mit einem Absorptionsmaximum im Wellenlängenbereich <450nm.

In einer weiteren Ausführungsform enthält das p-Materialsystem eine oder mehrere dotierte wide-gap Schichten.

In einer weiteren Ausführungsform enthält das Bauelement zwischen der photoaktiven i-Schicht und der auf dem Substrat befindlichen Elektrode eine p-dotierte Schicht, wobei die p-dotierte Schicht eine Ferminiveaulage hat, die höchstens 0,4eV, bevorzugt aber weniger als 0,3eV unterhalb des Elektronentransportnivaus der i-Schicht liegt.

In einer weiteren Ausführungsform enthält das Bauelement ein n-Schichtsystem zwischen der photoaktiven i-Schicht und der Gegenelektrode, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt.

In einer weiteren Ausführungsform ist das Akzeptor-Material ein Material aus der Gruppe der Fullerene bzw. Fullerenderivate (bevorzugt C₆₀ oder C₇₀) oder ein PTCDI-Derivat (Perylen-3,4,9,10-bis(dicarboximid)-Derivat).

In einer weiteren Ausführungsform ist das Donator-Material ein Oligomer, insbesondere ein Oligomer nach WO2006092134, ein Porphyrin-Derivat, ein Pentacen-Derivat oder ein Perylenderivat, wie DIP (Di-Indeno-Perylen), DBP (Di-benzoperylene).

In einer weiteren Ausführungsform enthält das p-Materialsystem ein TPD-Derivat(Triphenylamin-Dimer), eine Spiro-Verbindung, wie Spiropyrane, Spiroxazine, MeO-TPD (N,N,N',N'-Tetrakis(4-methoxyphenyl)-benzidin), Di-NPB (N,N'diphenyl-N,N'-bis(N,N'-*di*(1-naphthyl)-N,N'-diphenyl-(1,1'-biphenyl) 4,4'-diamine), MTDATA (4,4',4''-Tris-(N-3-methylphenyl-N-phenyl-amino)-triphenylamin), TNATA (4,4',4''-Tris[N-(1-naphthyl)-N-phenyl-amino]-triphenylamin), BPAPF (9,9-bis{4-[di-(p-biphenyl)aminophenyl]}fluorene), NPAPF (9,9-Bis[4-(N,N'-bis-naphthalen-2-yl-amino)phenyl]-9H-fluorene), Spiro-TAD (2,2',7,7'-Tetrakis-(diphenylamino)-9,9'-spirobifluoren), PV-TPD (N,N-di 4-2,2-diphenyl-ethen-1-yl-phenyl-N,N-di 4-methylphenylphenylbenzidine), 4P-TPD (4,4'-bis-(N,N-diphenylamino)-tetraphenyl), oder ein in DE102004014046 beschriebenes p-Material.

In einer weiteren Ausführungsform enthält das n-Materialsystem Fullerene, wie beispielsweise C₆₀, C₇₀; NTCDA (1,4,5,8-Naphthalene-tetracarboxylic-dianhydride), NTCDI (Naphthalenetetracarboxylic diimide) oder PTCDI (Perylen-3,4,9,10-bis(dicarboximid).

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform bestehen die Elektroden aus einem Metall (z.B. Al, Ag, Au oder eine Kombination aus diesen), einem leitfähigen Oxid, insbesondere ITO, ZnO:Al oder einem anderen TCO (Transparent Conductive Oxide), einem leitfähigen Polymer, insbesondere PEDOT/PSS Poly(3,4-ethylenedioxythiophene)poly(styrenesulfonate) oder PANI (Polyanilin), oder aus einer Kombination aus diesen Materialien.

In einer weiteren Ausführungsform der Erfindung wird durch Verwendung von Lichtfallen der optische Weg des einfallenden Lichtes im aktiven System vergrößert.

In einer weiteren Ausführungsform wird die Lichtfalle dadurch realisiert, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird. Ultradünne Bauelemente weisen auf strukturierten Substraten eine erhöhten Gefahr zur Bildung lokaler Kurzschlüsse auf, so dass durch eine solche offensichtliche Inhomogenität letztlich die Funktionalität des gesamten Bauelements gefährdet ist. Diese Kurzschlussgefahr wird durch die Verwendung der dotierten Transportschichten verringert.

In einer weiteren Ausführungsform der Erfindung wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann.

In einer weiteren Ausführungsform der Erfindung wird die Lichtfalle dadurch realisiert, dass eine dotierte wide-gap-Schicht eine glatte Grenzfläche zur i-Schicht und eine raue Grenzfläche zum reflektierenden Kontakt hat. Die raue Grenzfläche kann beispielsweise durch eine periodische Mikrostrukturierung erreicht werden. Besonders vorteilhaft ist die raue Grenzfläche, wenn sie das Licht diffus reflektiert, was zu einer Verlängerung des Lichtweges innerhalb der photoaktiven Schicht führt.

In einer weiteren Ausführungsform wird die Lichtfalle dadurch realisiert, dass das Bauelement auf einem periodisch mikrostrukturierten Substrat aufgebaut wird und eine dotierte wide-gap-Schicht eine glatte Grenzfläche zur i-Schicht und eine raue Grenzfläche zum reflektierenden Kontakt hat.

In einer weiteren Ausführungsform der Erfindung ist die Gesamtstruktur mit transparentem Grund- und Deckkontakt versehen.

In einer weiteren Ausführungsform der Erfindung werden die erfindungsgemäßen photoaktiven Bauelemente auf gekrümmten Oberflächen, wie beispielsweise Beton, Dachziegeln, Ton, Autoglas, etc. verwendet. Dabei ist es vorteilhaft, dass die erfindungsgemäßen organischen Solarzellen gegenüber herkömmlichen anorganischen Solarzellen auf flexiblen Trägern wie Folien, Textilen, etc. aufgebracht werden können.

In einer weiteren Ausführungsform der Erfindung werden die erfindungsgemäßen photoaktiven Bauelemente auf eine Folie oder Textil aufgebracht, welche ein Adhäsionsmittel, wie beispielsweise einen Klebstoff aufweist. Dadurch ist es möglich eine Solarklebefolie herzustellen, welche nach Bedarf auf beliebigen Oberflächen angeordnet werden kann. So kann eine selbsthaftende Solarzelle erzeugt werden.

In einer weiteren Ausführungsform weisen die erfindungsgemäßen photoaktiven Bauelemente ein anderes Adhäsionsmittel in Form einer Klettverschlussverbindung auf.

In einer weiteren Ausführungsform werden die erfindungsgemäßen photoaktiven Bauelemente in Verbindung mit Energiepuffer bzw. Energiespeichermedium wie beispielsweise Akkus, Kondensatoren, etc. zum Anschluss an Verbraucher bzw. Geräte verwendet.

In einer weiteren Ausführungsform werden die erfindungsgemäßen photoaktiven Bauelemente in Kombination mit Dünnfilmbatterien verwendet.

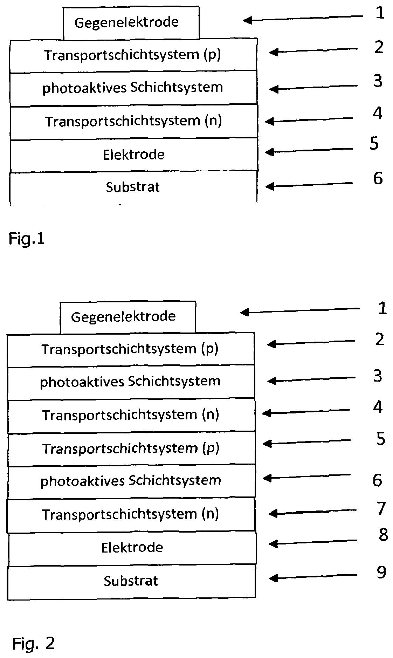

Die Erfindung soll nachfolgend näher anhand einiger Ausführungsbeispiele eingehender erläutert werden. Es zeigen in
Fig. 1 eine Einzelzelle mit einer substratnahen Elektrode 5 auf einem Substrat 6, einer Transportschicht 4, einem photoaktiven Schichtsystem 3 eine Transportschicht 2 und einer Gegenelektrode 1,
Fig. 2 eine Tandemzelle mit einer substratnahen Elektrode 5 auf einem Substrat 6, zweimal eine Abfolge von einer Transportschicht 4 und 7, einem photoaktiven Schichtsystem 3 und 6 eine Transportschicht 2 und 5, 2 und einer Gegenelektrode 1,

In den aufgeführten Ausführungsbeispielen sind beispielhaft einige erfindungsgemäßen Bauelemente aufgezeigt. Die Ausführungsbeispiele sollen die Erfindung beschreiben ohne sich auf diese zu beschränken.

In einem Anwendungsbeispiel sind beispielhaft einige erfindungsgemäße Bauelemente als Solarzelle wie folgt aufgebaut:

### Ausführungsbeispiel 1:

### Substrat (1), Grundkontakt (2), n-dotierte Transportschicht (3), Absorbersystem (4), Deckkontakt (6)

Wobei die Transportschichten üblicherweise 10-100nm dick sind. Als n-Dotand und/ wird eine der erfindungsgemäßen Verbindungen eingesetzt.

### Bezugszeichenliste

1 Substrat
2 Elektrode
3 Transportschichtsystem (ETL bzw. HTL), n-dotiert bzw. p-dotiert
4 photoaktives Schichtsystem
5 Transportschichtsystem (ETL bzw. HTL), n-dotiert bzw. p-dotiert
6 Gegenelektrode
11 Substrat
12 Elektrode
13 HTL oder ETL-Schichtsystem, n-dotiert bzw. p-dotiert
14 Mischschicht 1
15 Mischschicht 2
16 HTL oder ETL-Schichtsystem, n-dotiert bzw. p-dotiert
17 Elektrode
18 Weg des einfallenden Lichts

## Patentansprüche

1. Organisches elektronisches oder optoelektronisches Bauelement mit einer Elektrode und einer Gegenelektrode und einem Schichtsystem zwischen der Elektrode und der Gegenelektrode, wobei das Schichtsystem mindestens eine organische Schicht und mindestens eine dotierte Schicht enthält, **dadurch gekennzeichnet, dass** der Dotand in der dotierten Schicht eine stärkere Lewis-Base als 1,8-bis-(dimethylamino)-napthalen ist, wobei der Dotand mindesten 10 Atome besitzt.

2. Bauelement nach Anspruch 1, **dadurch gekennzeichnet, dass** der Dotand eine organische, metallorganische oder anorganische Verbindung ist.

3. Bauelement nach einem der Ansprüche 1 und 2, **dadurch gekennzeichnet, dass** der Dotand mindestens 20, bevorzugt aber mehr als 30 und maximal 100 Atome besitzt.

4. Bauelement nach Anspruch 3, **dadurch gekennzeichnet, dass** der Dotand eine Verbindung der Formel ((R₂N)₂-C=N)ₙ-Ar ist, wobei R unabhängig voneinander C₁-C₅-Alkyl, jeweils substituiert oder unsubstituiert ist, wobei zwei benachbarte R miteinander verbunden sein können, und Ar ein Aryl oder Heteroaryl, bevorzugt aber Phenyl, Naphtyl oder Anthryl, und n eine ganze Zahl, bevorzugt 2, 3 oder 4 ist.

5. Bauelement nach einem der vorhergehenden Ansprüche, **dadurch gekennzeichnet, dass** der Dotand mit höchsten 35%, bevorzugt aber höchstens 30%, Masseanteil in der Schicht vorkommt.

6. Bauelement nach einem der vorhergehenden Ansprüche, **dadurch gekennzeichnet, dass** das Bauelement ein OLED, eine organische Solarzelle, ein Feldtransistor (OFET) oder ein Fotodetektor ist.

7. Verwendung von Verbindungen mit mindesten 10 Atome, die eine stärkere Lewis-Base als 1,8-bis-(dimethylamino)-napthalen darstellen zur Dotierung von Ladungsträgertransportschichten oder aktiven Schichten sowie als Einzelschichten in organischen elektronischen oder optoelektronischen Bauelementen.

## Claims

1. Organic electronic or optoelectronic component having an electrode and a counterelectrode and a layer system between the electrode and the counterelectrode, the layer system comprising at least one organic layer and at least one doped layer, **characterized in that** the dopant in the doped layer is a stronger Lewis base than 1,8-bis(dimethylamino)naphthalene, the dopant having at least 10 atoms.

2. Component according to Claim 1, **characterized in that** the dopant is an organic, organometallic or inorganic compound.

3. Component according to either of Claims 1 and 2, **characterized in that** the dopant has at least 20, but preferably more than 30 and a maximum of 100 atoms.

4. Component according to Claim 3, **characterized in that** the dopant is a compound of the formula ((R₂N)₂-C=N)ₙ-Ar where R is independently C₁-C₅-alkyl, in each case substituted or unsubstituted, where two adjacent R may be joined to one another, and Ar is an aryl or heteroaryl, but preferably phenyl, naphthyl or anthryl, and n is an integer, preferably 2, 3 or 4.

5. Component according to any of the preceding claims, **characterized in that** the dopant occurs in the layer with a proportion by mass of at most 35%, but preferably at most 30%.

6. Component according to any of the preceding claims, **characterized in that** the component is an OLED, an organic solar cell, a field transistor OFET) or a photodetector.

7. Use of compounds having at least 10 atoms which are a stronger Lewis base than 1,8-bis(dimethylamino)naphthalene for doping of charge carrier transport layers or active layers, and as individual layers in organic electronic or optoelectronic components.

## Revendications

1. Composant organique électronique ou optoélectronique doté d'une électrode et d'une contre-électrode ainsi que d'un système de couches entre l'électrode et la contre-électrode, le système de couches présentant au moins une couche organique et au moins une couche dopée, **caractérisé en ce que** l'agent de dopage de la couche dopée représente une base de Lewis plus forte que le 1,8-bis-(diméthylamino)-naphtalène, l'agent de dopage possédant au moins 10 atomes.

2. Composant selon la revendication 1, **caractérisé en ce que** l'agent de dopage est un composé organique, organométallique ou minéral.

3. Composant selon l'une des revendications 1 et 2, **caractérisé en ce que** l'agent de dopage possède au moins 20, de préférence plus de 30 et au plus 100 atomes.

4. Composant selon la revendication 3, **caractérisé en ce que** l'agent de dopage est un composé de formule ((R2N)2-C=N)n-Ar, dans laquelle les R représentent indépendamment les uns des autres des alkyles en C1 à C5, substitués ou non substitués, deux R voisins pouvant être reliés l'un à l'autre et Ar représentant un aryle ou un hétéroaryle, mais de préférence un phényle, naphtyle ou anthryle, n étant un nombre entier, de préférence 2, 3 ou 4.

5. Composant selon l'une des revendications précédentes, **caractérisé en ce que** l'agent de dopage représente au plus 35 % mais de préférence au plus 30 % en masse de la couche.

6. Composant selon l'une des revendications précédentes, **caractérisé en ce que** le composant est une OLED, une cellule solaire organique, un transistor à effet de champ (OFET) ou un photodétecteur.

7. Utilisation de composés contenant au moins 10 atomes et qui représente une base de Lewis plus forte que le 1,8-bis-(diméthylamino)-naphtalène, pour le dopage de couches de transport de porteurs de charge ou de couches actives, ainsi que comme couches individuelles dans des composants électroniques ou optoélectroniques organiques.
